# FASCICULE DE BREVET EUROPEEN

(11) **EP 1 442 154 B1**
(45) Date de publication et mention de la délivrance du brevet: **19.01.2011**
(21) Numéro de dépôt: 02796837.9
(22) Date de dépôt: 05.11.2002
(51) Int. Cl.: C23C 16/458, C23C 16/00, C23C 16/04

(54) **PROCEDE DE REALISATION D'UN REVETEMENT CONTINU A LA SURFACE D'UNE PIECE**
VERFAHREN ZUR HERSTELLUNG EINES KONTINUIERLICHEN ÜBERZUGS AN DER OBERFLÄCHE EINES BAUTEILS
METHOD FOR PRODUCING A CONTINUOUS COATING AT THE SURFACE OF A COMPONENT

(30) Priorité: 06.11.2001 FR 0114313
(43) Date de publication de la demande: 04.08.2004
(73) Titulaire: Snecma Propulsion Solide, 33187 Le Haillan Cedex (FR)
(72) Inventeur: THEBAULT, Jacques, F-33200 Bordeaux (FR); PELLETAN, Jean-Eric, F-33160 ST Médard en Jalles (FR); DAVID, Laurent, F-33290 Blanquefort (FR); GIRARD, Philippe, F-33290 Le Pian Medoc (FR)
(74) Mandataire: Joly, Jean-Jacques
(86) Numéro de dépôt international: PCT/FR2002/003775
(87) Numéro de publication internationale: WO 2003/040429

(56) Documents cités:
- EP-A1- 0 172 082
- WO-A1-87/04733
- US-A- 4 472 476
- US-A- 4 752 503
- US-A- 4 823 734

## Description

### Arrière-plan de l'invention

L'invention concerne la réalisation d'un revêtement continu à la surface d'une pièce.

Le domaine d'application de l'invention est plus particulièrement la formation d'un revêtement de protection sur des pièces en un matériau sensible à la corrosion par oxydation et/ou la formation d'un revêtement d'étanchéification de pièces en un matériau poreux réfractaire.

Les matériaux concernés sont typiquement le carbone, le graphite et les matériaux composites thermostructuraux tels que les composites carbone/carbone (C/C) et les composites à matrice céramique avec renfort fibreux en carbone (par exemple les composites (C/SiC) ou avec renfort fibreux en céramique (par exemple SiC/SiC), du carbone pouvant alors être présent au niveau d'une interphase entre fibres céramiques et matrice céramique.

Selon l'utilisation envisagée, la formation d'un revêtement continu sur la surface extérieure de pièces en de tels matériaux est nécessaire pour leur assurer une bonne tenue en milieu oxydant à température élevée, et/ou pour étanchéifier leur surface, les matériaux tels que carbone, graphite et surtout composites thermostructuraux présentant une porosité interne plus ou moins importante.

Une couche de revêtement peut être formée par voie gazeuse éventuellement combinée avec une voie liquide (voie mixte).

La voie gazeuse consiste dans un dépôt ou une infiltration chimique en phase vapeur. Un gaz contenant au moins un précurseur du matériau du revêtement à réaliser est amené au contact de la pièce dans des conditions de température et de pression qui favorisent la formation de ce matériau par décomposition du précurseur ou réaction entre plusieurs constituants de celui-ci. Dans le cas de l'infiltration chimique en phase vapeur, le dépôt du matériau de revêtement se produit également au sein de la porosité du matériau de la pièce et un revêtement de surface est formé après comblement de la porosité au moins au voisinage de la surface.

La voie liquide consiste à revêtir la surface de la pièce par un liquide précurseur du matériau du revêtement, typiquement une résine éventuellement additionnée d'un solvant et de charge. Après réticulation, la transformation du précurseur est obtenue par traitement thermique. La formation du revêtement est complétée par voie gazeuse.

Pour la formation du revêtement, la pièce est usuellement placée sur un ou plusieurs supports avec un contact limité entre la pièce et le ou chaque support.

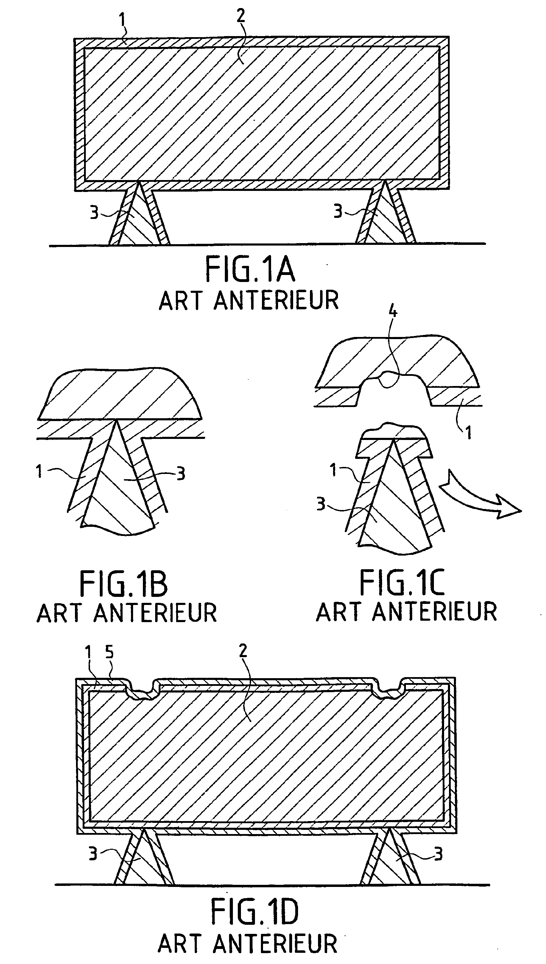

Dans le cas par exemple d'un revêtement formé par infiltration ou dépôt chimique en phase vapeur, le matériau du revêtement formé 1 se dépose sur la pièce 2 et sur les supports 3, comme le montre très schématiquement la figure 1A et, plus en détail, la figure 1B. Lorsque la pièce est séparée du support, la rupture qui se produit laisse sur la pièce une zone 4 non protégée (figure 1C), notamment quand le matériau de la pièce, tel que le graphite, a une résistance mécanique moindre que celle du matériau de revêtement, tel que du carbure de silicium (SiC).

Un tel défaut est inacceptable car il laisse une voie d'accès à l'oxygène du milieu ambiant pour attaquer le matériau de la pièce.

La solution généralement adoptée consiste à réaliser une deuxième couche de revêtement 5 (figure 1D) en replaçant la pièce sur les supports après l'avoir retournée.

La réalisation de deux dépôts successifs représente un surcoût substantiel. En outre, le même risque d'endommagement ne peut pas être exclu lors de la séparation entre la pièce et les supports, après le deuxième dépôt.

Une semblable difficulté est rencontrée lorsque le revêtement de la pièce doit être réalisé par voie liquide sur l'intégralité de la surface extérieure.

### Objet et résumé de l'invention

L'invention a pour but de fournir un procédé permettant de réaliser un revêtement continu sur toute la surface d'une pièce placée sur un ou plusieurs supports, sans avoir à recourir à deux dépôts successifs du matériau de revêtement et sans risque de création d'un défaut dans le revêtement lors de la séparation entre la pièce et le ou les supports.

Ce but est atteint grâce à un procédé selon lequel :
- le ou chaque support est muni d'une couche de séparation en un matériau de moindre résistance mécanique que celui du revêtement à réaliser,
- une couche de continuité en un matériau constitutif du revêtement à réaliser est interposée entre le ou chaque support et la pièce, au moins au niveau de la ou chaque zone de supportage,
- le revêtement est formé par infiltration ou dépôt chimique en phase vapeur, et
- la pièce est séparée ensuite du ou de chaque support par rupture au sein de la couche de séparation, la continuité du revêtement de la pièce au niveau de la ou chaque zone de supportage étant assurée par la partie de revêtement issue de la couche de continuité et restant en place sur la pièce.

Ainsi, la présence d'une zone d'affaiblissement constituée par la couche de séparation entre le ou chaque support et la pièce associée à l'interposition d'une couche de continuité, permet de préserver la continuité du revêtement finalement formé.

Avantageusement, la couche de séparation est en un matériau à structure feuilletée, la séparation entre support et pièce étant réalisée par clivage au sein de ce matériau.

Le matériau de la couche de séparation peut être choisi parmi le carbone pyrolytique de type laminaire, du nitrure de bore à structure hexagonale, du graphite feuilleté ou des matériaux silicoalumineux, à structure lamellaire, tels que talc ou argiles.

Selon une particularité du procédé, la couche de continuité peut être formée sur le ou chaque support, au-dessus de la couche de séparation. Ainsi, la couche de continuité vient au contact de la pièce lorsque celle-ci est placée sur le ou chaque support et reste sur la surface de la pièce lorsque le ou les supports sont retirés avec rupture au sein de la couche de séparation.

La couche de continuité peut en variante être formée localement sur la pièce, au moins au niveau des zones de supportage.

Selon une autre particularité du procédé, la couche de continuité est en un matériau semblable à celui du revêtement à réaliser. Un traitement de surface préalable de la couche de continuité est avantageusement réalisé pour favoriser l'adhérence avec le matériau du revêtement. Ce traitement de surface peut être un traitement thermique ou un traitement par attaque acide.

En variante, la couche de continuité est en un matériau poreux. Le revêtement est alors réalisé par infiltration chimique en phase vapeur, avec densification au moins partielle du matériau poreux de la couche de continuité.

### Brève description des dessins

L'invention sera mieux comprise à la lecture de la description faite ci-après, à titre indicatif mais non limitatif, en référence aux dessins annexés, sur lesquels :
- les figures 1A à 1D, déjà décrites, montrent des étapes successives d'un procédé de l'art antérieur pour former un revêtement continu sur un substrat par infiltration ou dépôt chimique en phase vapeur;
- la figure 2 est une vue d'une pièce placée sur des supports dans un four d'infiltration chimique en phase vapeur ;
- la figure 3 est une vue à échelle agrandie et en coupe d'un support de pièce selon un mode de mise en oeuvre d'un procédé conforme à l'invention ;
- la figure 4 est une vue de détail à échelle agrandie au niveau du contact entre un support tel que celui de la figure 3 et une pièce, après formation d'un revêtement par infiltration ou dépôt chimique en phase vapeur ;
- la figure 5 est une vue de détail à échelle agrandie analogue à la figure 4, mais après séparation entre support et pièce ;
- la figure 6 est une vue à échelle agrandie et en coupe d'un support de pièce selon un autre mode de mise en oeuvre d'un procédé conforme à l'invention ;
- la figure 7 est une vue de détail à échelle agrandie au niveau du contact entre un support tel que celui de la figure 6 et une pièce, après formation d'un revêtement par infiltration chimique en phase vapeur ;
- la figure 8 est une vue de détail à échelle agrandie analogue à la figure 7, mais après séparation entre support et pièce ;
- la figure 9 est une vue de détail à échelle agrandie au niveau du contact entre un support et une pièce selon encore un autre mode de mise en oeuvre d'un procédé conforme à l'invention ;
- la figure 10 est une vue de détail à échelle agrandie semblable à la figure 9, mais après formation d'un revêtement par infiltration chimique en phase vapeur ; et
- la figure 11 est une vue de détail à échelle agrandie semblable à la figure 10, mais après séparation entre support et pièce ;

### Description détaillée de modes de réalisation de l'invention

Un premier mode de mise en oeuvre d'un procédé selon l'invention sera décrit ci-après dans le cadre de la formation, par infiltration chimique en phase vapeur, d'un revêtement continu en carbure de silicium (SiC) sur toute la surface d'une pièce en graphite, afin de protéger celle-ci de l'oxydation.

En comparaison avec le processus de dépôt chimique en phase vapeur, l'infiltration chimique en phase vapeur est conduite dans des conditions de température et de pression qui favorisent la diffusion de la phase gazeuse réactive au sein de la porosité de surface de la pièce en graphite. Aussi, afin de garantir la continuité du revêtement et son ancrage à la surface de la pièce, on utilisera de préférence un procédé d'infiltration chimique en phase vapeur. L'utilisation de procédés de dépôt chimique en phase vapeur reste toutefois dans le cadre de l'invention, par exemple dépôt chimique en phase vapeur à basse pression connu dans l'industrie électronique sous le vocable LPCVD ("Low Pressure Chemical Vapor Deposition").

La pièce 10 en graphite à revêtir est placée sur des supports 20 à l'intérieur d'un four 30 d'infiltration chimique en phase vapeur. Plusieurs pièces peuvent être chargées simultanément dans le four, sur différents plateaux 32. Le revêtement SiC est obtenu en utilisant une phase gazeuse pouvant contenir du méthyltrichlorosilane (MTS) comme précurseur de SiC. Des procédés et installations pour la formation de dépôts SiC par infiltration chimique en phase vapeur sont bien connus. On pourra se référer au document EP 0 256 073.

Les supports 20 ont une forme conique ou pyramidale offrant par leur sommet une zone de contact de surface limitée avec la pièce 10. D'autres formes de supports sont envisageables, par exemple des barreaux prismatiques offrant une surface de contact limitée le long d'une arête.

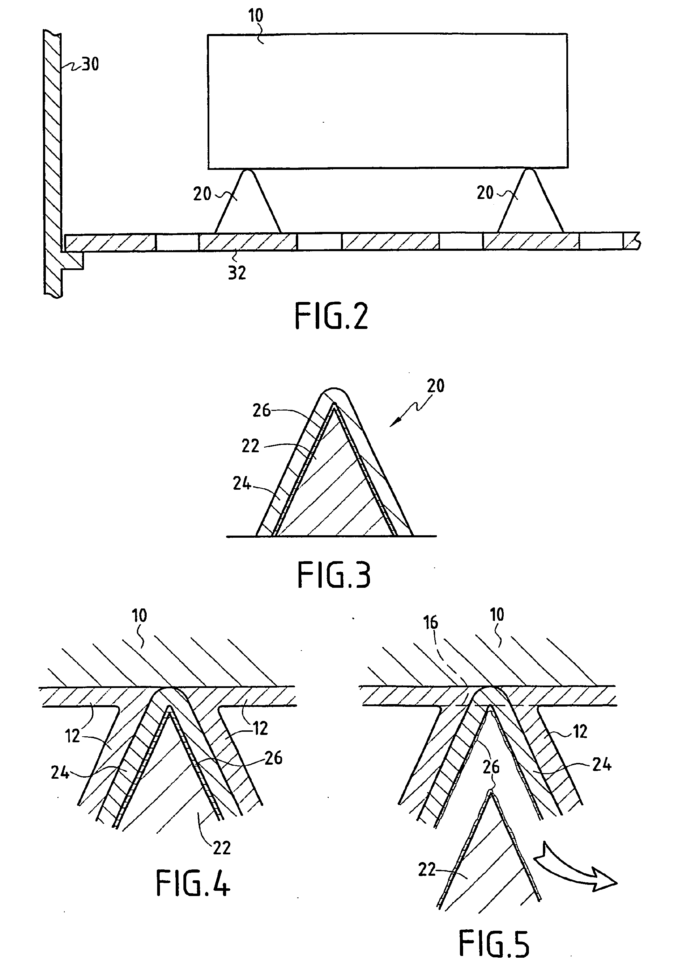

Comme le montre plus en détail la figure 3, chaque support 20 comprend un substrat 22 en matériau réfractaire, par exemple en graphite ou en matériau composite thermostructural tel qu'un matériau composite C/C, et une couche externe 24 en carbure de silicium destinée à constituer une couche de continuité du revêtement SiC à réaliser. Une couche de séparation 26 en matériau réfractaire ayant une moindre résistance mécanique que le SiC de la couche 24 est interposée entre le substrat 22 et la couche 24.

La couche de séparation 26 définit une zone d'affaiblissement. Elle est avantageusement en un matériau à structure lamellaire, ou matériau clivable, tel que du carbone pyrolytique (PyC) de type laminaire, du nitrure de bore (BN) hexagonal, du graphite feuilleté ou autre matériau réfractaire tels que des silicoalumineux lamellaires, comme du talc ou des argiles.

Une couche de PyC ou BN peut être obtenue par dépôt ou infiltration chimique en phase vapeur. On pourra se référer au document EP 0 172 082 qui décrit la réalisation d'une interphase lamellaire PyC ou BN à faible résistance au cisaillement entre des fibres et une matrice d'un matériau composite thermostructural à fibres de renfort réfractaires et matrice céramique.

Une couche en BN ou en graphite feuilleté peut aussi être obtenue par projection (pulvérisation) puis lissage éventuel selon une technique connue utilisée notamment pour former une couche d'agent de démoulage sur la paroi d'un moule, par exemple avec le produit à base de BN de la société française "ACHESON FRANCE" commercialisé sous la dénomination "Puisé Aéro A", ou le produit à base graphite de la même société commercialisé sous la dénomination "Graphoil D31A".

Une couche de talc ou d'argile peut également être obtenue par projection sous forme finement divisée puis par lissage.

L'épaisseur de la couche 26 doit être suffisante pour permettre ultérieurement une séparation par rupture au sein de cette couche, sans endommagement de la couche 24 en SiC.

Cette épaisseur doit toutefois rester relativement limitée pour assurer une adhérence suffisante de la couche externe 24 jusqu'à séparation finale.

L'épaisseur de la couche 26 est choisie de préférence entre 0,1 micron et 20 microns, typiquement entre 0,5 micron et 5 microns.

La couche 24 en SiC est formée par dépôt ou infiltration chimique en phase vapeur. Son épaisseur est choisie au moins égale à celle du revêtement à former sur la pièce 10.

Après chargement dans le four, un revêtement SiC 12 est formé sur la pièce 10 et sur les faces latérales exposées des supports 20, comme le montre en détail la figure 4.

Après formation du revêtement 12, la pièce 10 est retirée du four avec les supports 20, puis les supports 20 sont séparés physiquement de la pièce 10. Du fait de la présence de la couche d'affaiblissement 26, la séparation entre support et pièce se fait au sein de celle-ci, comme le montre la figure 5.

La continuité du revêtement SiC sur la pièce est assurée, au niveau de la zone de contact avec un support, par la couche 24 du support qui reste accrochée sur la pièce 10. La partie excédentaire de couche 24 peut ensuite éventuellement être éliminée par usinage (voir le trait interrompu 16 sur la figure 5), de sorte qu'un revêtement continu en SiC ayant une épaisseur sensiblement constante est formé sur toute la surface de la pièce 10.

Afin d'assurer une bonne adhérence entre la couche 24 et le revêtement 12, on réalise de préférence la couche 24 par un processus d'infiltration chimique en phase vapeur semblable à celui utilisé pour le revêtement 12, de manière à obtenir des dépôts SiC de même structure. En outre, avant réalisation du revêtement 12, un traitement de surface peut être réalisé sur la surface de la couche externe 24, afin de la débarrasser de toute impureté et/ou d'un film de silice (SiO₂) qui s'y serait formé, afin de faciliter une liaison avec forte adhérence avec le revêtement 12.

Un tel traitement de surface peut consister en un traitement thermique, par exemple à une température de 1200°C à 1900°C sous vide secondaire. Un film de silice est éliminé par la réaction avec SiC, c'est-à-dire : SiC+2SiO₂ → 3SiO+CO.

En variante, le traitement de surface est une attaque acide, par exemple par acide fluorhydrique (HF) également pour éliminer le film de SiO₂ de surface.

Bien que l'on ait envisagé ci-avant la formation d'un revêtement SiC sur une pièce en graphite, le procédé selon l'invention peut être utilisé pour former tout type de revêtement continu susceptible d'être obtenu par dépôt ou infiltration chimique en phase vapeur, sur différents types de substrats. Ainsi, un revêtement continu de protection contre l'oxydation d'une pièce réalisée au moins en partie en carbone ou graphite peut être réalisé en un matériau céramique réfractaire choisi notamment parmi des carbures, autres que SiC, et des nitrures. Le gaz réactif utilisé est choisi en fonction de la nature du revêtement à former. On pourra se référer au document FR 2 401 888, par exemple, qui décrit la réalisation de revêtements de différentes natures par infiltration ou dépôt chimique en phase vapeur.

On notera en outre que la formation d'une couche externe et d'une couche de séparation sur les supports de pièces pourra être limitée aux zones des supports destinées à être en contact avec les pièces.

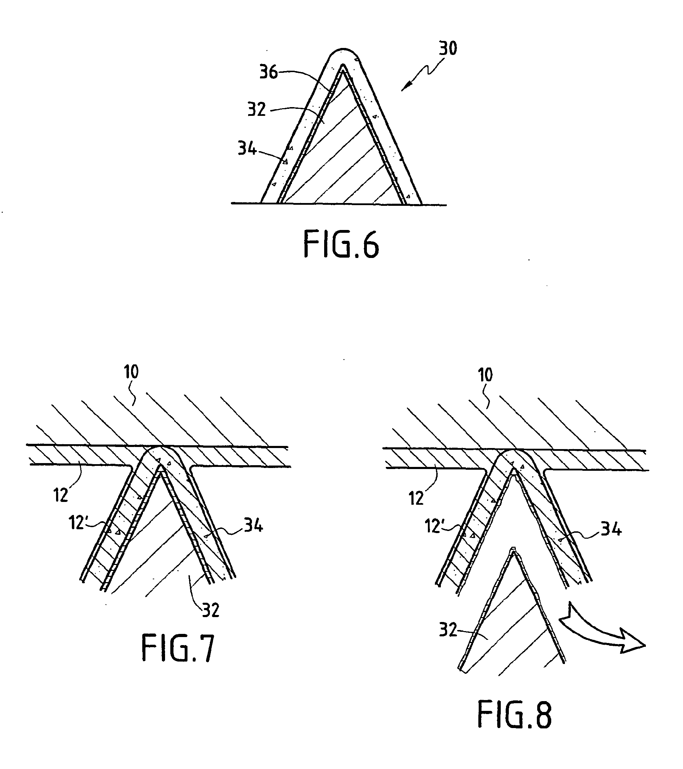

La figure 6 illustre une variante de réalisation d'un support 30 pour une pièce à revêtir.

Le support 30 comporte un substrat 32 en matériau réfractaire muni d'une couche de séparation 36. Le substrat 32 et la couche 36 sont par exemple semblables au substrat 22 et à la couche 26 décrits plus haut en référence à la figure 3.

Le support 30 se distingue de celui 20 de la figure 3 en ce qu'il comporte une couche externe 34 en matériau poreux, formée sur la couche de séparation 36. La couche 34 est une couche destinée à assurer la continuité du revêtement formé ultérieurement sur une pièce reposant sur le support 30.

La couche poreuse 34 est par exemple réalisée par dépôt sur la couche de séparation 36, au moins dans la partie supérieure du support 30, d'une composition liquide comportant un précurseur d'un matériau semblable à celui du revêtement à former. Dans le cas d'un revêtement SiC, le précurseur est par exemple une résine polycarbosilane (PCS). D'autres précurseurs peuvent être utilisés, par exemple polycarbosiloxanes ou silicones. La résine, éventuellement additionnée d'un solvant afin d'ajuster la viscosité peut être chargée de poudre SiC. Après enduction, la résine est réticulée puis une céramisation est réalisée par traitement thermique.

La pièce 10 à revêtir est placée sur un ou plusieurs supports 30 et un revêtement SiC est formé par infiltration chimique en phase vapeur.

Comme le montre la figure 7, après infiltration, la couche 34 est densifiée et un revêtement 12 est formé sur la pièce 10. L'infiltration est poursuivie jusqu'à comblement de la porosité, au moins dans la partie superficielle, de la couche 34 et développement d'un revêtement externe 12' sur celle-ci, d'épaisseur inférieure au revêtement 12.

Le retrait du support se fait par rupture au sein de la couche de séparation 36. Un revêtement continu en SiC est obtenu sur toute la surface de la pièce 10, la continuité au niveau d'une zone de supportage étant procurée par la couche de continuité 34 en SiC densifiée par du SiC (figure 8). La partie excédentaire des couches 34 et 12' peut ensuite être éventuellement éliminée avec arasement au niveau de la surface de la couche 12.

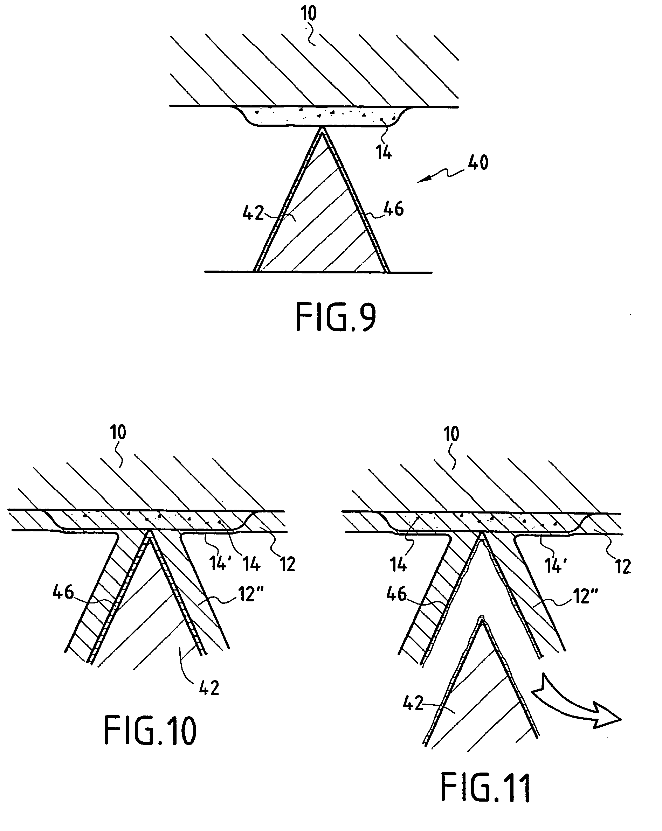

Les figures 9 à 11 illustrent une variante du procédé des figures 6 à 8.

Selon cette variante, une couche de continuité poreuse 14 est formée non pas sur une couche de séparation 46 d'un ou plusieurs supports 40, mais sur la surface de la pièce 10.

La couche 14 est formée sur une partie de la surface de la pièce 10, éventuellement en plusieurs parties séparées, de manière à être présente au moins au niveau de la ou chaque zone de supportage. Le support 40 s'appuie donc par la couche de séparation 46 sur la couche 14 (figure 9). Le matériau de la couche 14 peut être identique à celui de la couche 34 décrite plus haut. Le support 40 comprend un substrat 42 revêtu par la couche de séparation 46, ces derniers étant semblables au substrat 22 et à la couche de séparation 26 du support 20 décrit plus haut.

Un revêtement SiC est formé par infiltration chimique en phase vapeur. La couche poreuse 14 est densifiée tandis que des revêtements 12 et 12" sont formés sur les parties de surface de la pièce non revêtues par la couche poreuse 14 et sur la couche de séparation 46. L'infiltration est réalisée de manière à combler la porosité de la couche 14, au moins dans sa partie superficielle, et à développer un revêtement externe 14' sur celle-ci, d'épaisseur inférieure à celle du revêtement 12 (figure 10).

Le retrait du support se fait par rupture au sein de la couche de séparation. Un revêtement continu SiC est obtenu sur toute la surface de la pièce, la continuité au niveau de la ou chaque zone de supportage étant obtenue par la couche de continuité 14 densifiée par du SiC et munie du revêtement 14' (figure 11). La partie excédentaire de revêtement 12" peut être éventuellement éliminée avec arasement par exemple au niveau de la surface du revêtement 14'.

## Revendications

1. Procédé de réalisation d'un revêtement continu sur toute la surface d'une pièce comprenant la mise en place de la pièce sur un ou plusieurs supports et la formation du revêtement **caractérisé en ce que**
- le ou chaque support est muni d'une couche de séparation en un matériau de moindre résistance mécanique que celui du revêtement à réaliser,
- une couche de continuité en un matériau constitutif du revêtement à réaliser est interposée entre le ou chaque support et la pièce, au moins au niveau de la ou chaque zone de supportage,
- le revêtement est formé par dépôt ou infiltration chimique en phase vapeur, et
- la pièce est séparée ensuite du ou de chaque support par rupture au sein de la couche de séparation, la continuité du revêtement de la pièce au niveau de la ou chaque zone de supportage étant assurée par la partie de revêtement issue de la couche de continuité et restant en place sur la pièce.

2. Procédé selon la revendication 1, **caractérisé en ce que** la couche de séparation est en un matériau à structure feuilletée, la séparation entre support et pièce étant réalisée par clivage au sein de ce matériau.

3. Procédé selon la revendication 2, **caractérisé en ce que** le matériau de la couche de séparation est choisi parmi le carbone pyrolytique de type laminaire, du nitrure de bore à structure hexagonale, du graphite feuilleté ou des matériaux silicoalumineux, à structure lamellaire, tels que talc ou argiles.

4. Procédé selon l'une quelconque des revendications 1 à 3, **caractérisé en ce que** la couche de continuité est formée sur le ou chaque support, au-dessus de la couche de séparation.

5. Procédé selon l'une quelconque des revendications 1 à 3, **caractérisé en ce que** la couche de continuité est formée localement sur la pièce, au moins au niveau de la ou chaque zone de supportage.

6. Procédé selon l'une quelconque des revendications 4 et 5, **caractérisé en ce que** la couche de continuité est en matériau poreux.

7. Procédé selon la revendication 6, **caractérisé en ce que** le revêtement est réalisé par infiltration chimique en phase vapeur avec densification au moins partielle de la couche de continuité.

8. Procédé selon la revendication 4, **caractérisé en ce que** la couche de continuité est en un matériau semblable à celui du revêtement à réaliser.

9. Procédé selon la revendication 8, **caractérisé en ce que**, avant dépôt ou infiltration chimique en phase vapeur, un traitement de surface de la couche de continuité est réalisé afin de favoriser l'adhérence avec le revêtement réalisé ensuite.

10. Procédé selon la revendication 9, **caractérisé en ce que** le traitement de surface est un traitement thermique.

11. Procédé selon la revendication 9, **caractérisé en ce que** le traitement de surface est un traitement par attaque acide.

12. Procédé selon l'une quelconque des revendications 1 à 11 pour la réalisation d'un revêtement continu de protection contre l'oxydation d'une pièce réalisée au moins en partie en carbone ou graphite.

13. Procédé selon l'une quelconque des revendications 1 à 12, **caractérisé en ce que** le revêtement continu formé sur toute la surface de la pièce est en matériau céramique réfractaire choisi parmi les carbures et les nitrures.

14. Procédé selon l'une quelconque des revendications 1 à 13, **caractérisé en ce que** le revêtement continu formé sur toute la surface de la pièce est en carbure de silicium.

## Claims

1. A method of making a continuous coating over the entire surface of a part, in which the part is put into place on one or more supports and the coating is formed thereon, the method being **characterized by** the steps of:
- providing the or each support with a separation layer of a material that is weaker than the material of the coating to be made;
- interposing a continuity layer of a component material of the coating to be made between the or each support and the part, at least in the or each support zone;
- forming the coating by chemical vapor infiltration or deposition; and
- subsequently separating the part from the or each support by rupture within the separation layer, the continuity of the coating on the part in the or each support zone being provided by the portion of the coating that comes from the continuity layer and that remains in place on the part.

2. A method according to claim 1, **characterized in that** the separation layer is made of a material of flaky structure, separation between the support and the part being achieved by cleavage within said material.

3. A method according to claim 2, **characterized in that** the material of the separation layer is selected from: laminar type pyrolytic carbon; hexagonal structure boron nitride; flake graphite; or flaky structure aluminosilicates such as talc or clays.

4. A method according to any one of claims 1 to 3, **characterized in that** the continuity layer is formed on the or each support over the separation layer.

5. A method according to any one of claims 1 to 3, **characterized in that** the continuity layer is formed locally on the part, at least over the or each support zone.

6. A method according to claim 4 or claim 5, **characterized in that** the continuity layer is made of a porous material.

7. A method according to claim 6, **characterized in that** the coating is made by chemical vapor infiltration with the continuity layer being densified at least partially.

8. A method according to claim 4, **characterized in that** the continuity layer is of a material similar to that of the coating to be made.

9. A method according to claim 8, **characterized in that** prior to chemical vapor infiltration or deposition, surface treatment is performed on the continuity layer in order to enhance bonding with the coating made subsequently.

10. A method according to claim 9, **characterized in that** the surface treatment is heat treatment.

11. A method according to claim 9, **characterized in that** the surface treatment is acid attack treatment.

12. A method according to any one of claims 1 to 11, for making a continuous coating on a part made at least in part out of carbon or graphite to provide the part with protection against oxidation.

13. A method according to any one of claims 1 to 12, **characterized in that** the continuous coating formed over the entire surface of the part is made of a refractory ceramic material selected from carbides and nitrides.

14. A method according to any one of claims 1 to 13, **characterized in that** the continuous coating formed over the entire surface of the part is made of silicon carbide.

## Patentansprüche

1. Verfahren zur Herstellung eines durchgehenden Überzugs auf der gesamten Oberfläche eines Teils, umfassend das Anordnen des Teils auf einem oder mehreren Trägern und die Ausbildung des Überzugs, **dadurch gekennzeichnet, daß**
- der oder jeder Träger mit einer Trennschicht aus einem Werkstoff, der eine geringere mechanische Festigkeit als der des herzustellenden Überzugs aufweist, versehen ist,
- eine Kontinuitätsschicht aus einem den herzustellenden Überzug bildenden Werkstoff zwischen dem oder jedem Träger und dem Teil, wenigstens im Bereich des oder jedes Tragbereichs eingefügt ist,
- der Überzug durch chemische Gasphasenabscheidung oder - infiltration gebildet wird und
- das Teil anschließend von dem oder jedem Träger durch einen Bruch innerhalb der Trennschicht getrennt wird, wobei die Kontinuität des Überzugs des Teils im Bereich des oder jedes Tragbereichs durch den aus der Kontinuitätsschicht hervorgegangenen und auf dem Teil verbleibenden Überzugsteil sichergestellt wird.

2. Verfahren nach Anspruch 1, **dadurch gekennzeichnet, daß** die Trennschicht aus einem Werkstoff mit Mehrschichtstruktur besteht, wobei die Trennung zwischen Träger und Teil durch Spaltung innerhalb dieses Werkstoffs vollzogen wird.

3. Verfahren nach Anspruch 2, **dadurch gekennzeichnet, daß** der Werkstoff der Trennschicht aus pyrolytischem Kohlenstoff laminarer Art, Bornitrid mit hexagonaler Struktur, Mehrschichtgraphit oder Tonerdesilikatmaterialen, mit lamellarer Struktur, wie Talkum oder Tone ausgewählt ist.

4. Verfahren nach einem der Ansprüche 1 bis 3, **dadurch gekennzeichnet, daß** die Kontinuitätsschicht auf dem oder jedem Träger oberhalb der Trennschicht gebildet wird.

5. Verfahren nach einem der Ansprüche 1 bis 3, **dadurch gekennzeichnet, daß** die Kontinuitätsschicht auf dem Teil lokal gebildet wird, wenigstens im Bereich des oder jedes Tragbereichs.

6. Verfahren nach einem der Ansprüche 4 und 5, **dadurch gekennzeichnet, daß** die Kontinuitätsschicht aus porösem Material besteht.

7. Verfahren nach Anspruch 6, **dadurch gekennzeichnet, daß** der Überzug durch chemische Gasphaseninfiltration mit wenigstens teilweiser Verdichtung der Kontinuitätsschicht hergestellt wird.

8. Verfahren nach Anspruch 4, **dadurch gekennzeichnet, daß** die Kontinuitätsschicht aus einem ähnlichen Werkstoff wie der herzustellende Überzug besteht.

9. Verfahren nach Anspruch 8, **dadurch gekennzeichnet, daß** vor der chemischen Gasphasenabscheidung oder -infiltration eine Oberflächenbehandlung der Kontinuitätsschicht durchgeführt wird, um die Haftung mit dem anschließend hergestellten Überzug zu begünstigen.

10. Verfahren nach Anspruch 9, **dadurch gekennzeichnet, daß** die Oberflächenbehandlung eine Wärmebehandlung ist.

11. Verfahren nach Anspruch 9, **dadurch gekennzeichnet, daß** die Oberflächenbehandlung eine Behandlung durch Ätzen ist.

12. Verfahren nach einem der Ansprüche 1 bis 11, für die Herstellung eines durchgehenden Überzugs zum Schutz gegen die Oxydation eines wenigstens teilweise aus Kohlenstoff oder Graphit gefertigten Teils.

13. Verfahren nach einem der Ansprüche 1 bis 12, **dadurch gekennzeichnet, daß** der auf der gesamten Oberfläche des Teils ausgebildete durchgehende Überzug aus feuerfestem keramischem Werkstoff, welcher aus den Karbiden und den Nitriden ausgewählt ist, besteht.

14. Verfahren nach einem der Ansprüche 1 bis 13, **dadurch gekennzeichnet, daß** der auf der gesamten Oberfläche des Teils ausgebildete durchgehende Überzug aus Siliziumkarbid besteht.
